# EUROPEAN PATENT SPECIFICATION

(11) **EP 0 484 290 B1**
(45) Date of publication and mention of the grant of the patent: **10.08.1994**
(21) Application number: 91830459.3
(22) Date of filing: 29.10.1991
(51) Int. Cl.: B23K 3/06, B23K 3/08, H01L 21/68

(54) **A support element for carrying hybrid circuits in a remelting furnace**
Element, das durch einen Umschmelzofen Hybridschaltkreise trägt
Elément support portant des circuits hybrides, dans un four à refusion

(30) Priority: 30.10.1990 IT 5334990 U
(43) Date of publication of application: 06.05.1992
(73) Proprietor: MARELLI AUTRONICA S.p.A., 20145 Milano (IT)
(72) Inventor: Scarano, Giuseppina, I-15033 Casale Monferrato (Alessandria) (IT); Fantinati, Gabriele, I-10154 Torino (IT)
(74) Representative: Quinterno, Giuseppe

(56) References cited:
- US-A- 3 588 998
- US-A- 3 721 379
- US-A- 4 512 510

## Description

The present invention relates to a support element for carrying hybrid circuits as they pass through a remelting furnace provided with a slat conveyor.

Typically, the hybrid circuits are produced on ceramic backings and, for making the welds, they are pissed through remelting furnaces which are fitted with infrared ray lamps and generally a slat conveyor.

During passage through the furnace, it is necessary for the hybrid circuit to be effectively and evenly heated over its entire surface in order to ensure satisfactory and reliable welding. During passage through the furnace, it is also necessary to avoid areas of the hybrid circuits becoming shaded, which might hamper the work or compromise the quality of the welds.

The object of the present invention is to provide a support element adapted to carry hybrid circuits provided with a ceramic substrate of quadrangular shape as they pass through a remelting furnace provided with a slat conveyor, the said support element making it possible to ensure correct and reliable execution of the welds.

This object is, according to the invention, achieved by a support element characterised in that it comprises a quadrangular frame of a metallic material, from the outer vertices of which extend four bearing appendages intended to be arranged on the slats of the conveyor and close to the inner vertices of which there are predisposed four recessed areas intended to receive and support the edges of the substrate of a hybrid circuit.

Ideally, the said support element is made from aluminium.

Preferably, the recessed areas for supporting the corners or edges of the substrate of a hybrid circuit are substantially crescent-shaped when viewed in plan.

Further characteristic features and advantages of the support element according to the invention will become apparent from the following detailed description given with reference to the appended drawings which are supplied by way of example and in which:
Figure 1 is a perspective view of a support element according to the invention,
Figure 2 is a plan view of the said support element and
Figure 3 and 4 are sectional views taken on the lines III-III and IV-IV respectively in Figure 2.

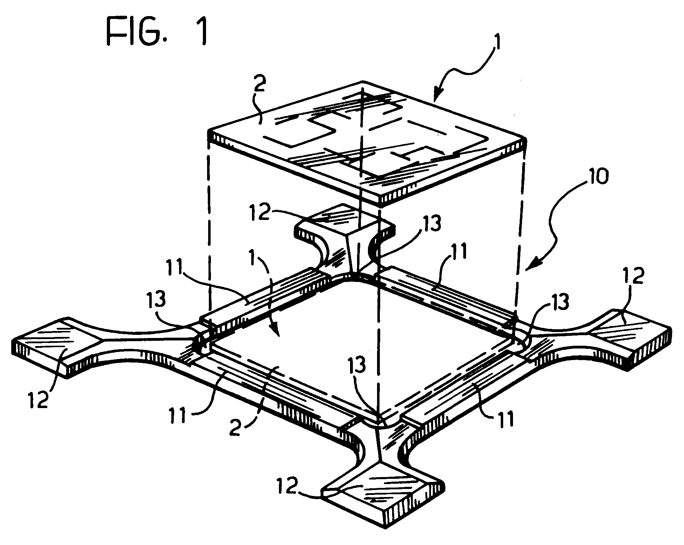

In Figure 1, reference numeral 1 indicates a hybrid circuit provided with a square ceramic substrate 2 intended to be passed through a remelting furnace on a slat conveyor in order to produce soldered joints between the parts and components carried on the upper surface.

For this purpose, according to the invention, a support element, generally designated 10, is used and is constituted essentially by a quadrangular frame 11 from the outer vertices of which extend diagonally four bearing appendages 12 intended to be placed on the slats of the conveyor of the remelting furnace.

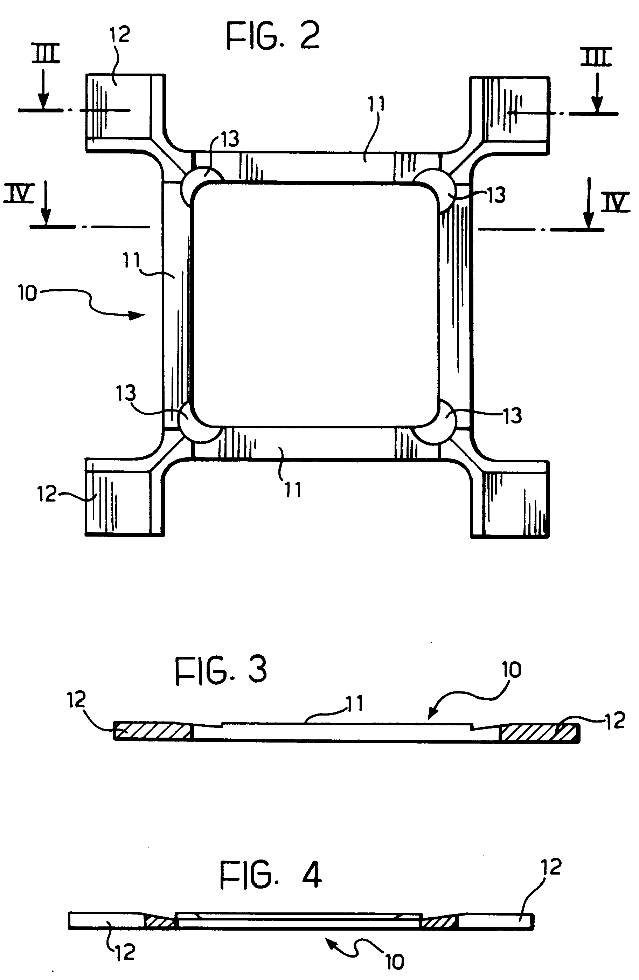

Close to the inner vertices of the frame 11 on the upper surface are four recessed areas 13 intended to receive and support the corners or edges of the substrate 2 of a hybrid circuit 1. As shown in Figures 1 and 2, the inner vertices of the frame 1 are rounded and the said recessed areas 13 are crescent-shaped when viewed in plan.

The support element is made from a metallic material which is a good heat conductor, for example aluminium, and its sides are preferably bevelled or rounded off to guarantee better exposure of the hybrid circuit to the infrared radiation in the remelting furnace.

## Claims

1. A support element (10) for carrying hybrid circuits (1) provided with a ceramic substrate (2) of quadrangular shape in a remelting furnace equipped with a slat conveyor, characterised in that it comprises a quadrangular frame (11) of metallic material, from the outer vertices of which extend four bearing appendages (12) intended to be arranged on the slats of the conveyor and close to the inner vertices of which there are predisposed four recessed areas (13) intended to receive and support the edges or corners of the substrate (2) of a circuit (1).

2. A support element (10) according to Claim 1, characterised in that the inner vertices of the said frame (11) are rounded.

3. A support element (10) according to Claim 1 or 2, characterised in that the said recessed areas (13) are crescent-shaped when viewed in plan.

4. A support element (10) according to any one of the preceding claims, characterised in that the said appendages (12) are of a substantially square shape.

5. A support element (10) according to any one of the preceding claims, characterised in that it is of aluminium.

## Patentansprüche

1. Halteelement (10) zum Tragen von Hybridschaltungsanordnungen (1), die ein keramisches Substrat (2) von viereckiger Gestalt aufweisen, in einem Umschmelzofen, der mit einem Plattenbandförderer ausgerüstet ist,
**dadurch gekennzeichnet,**
daß das Halteelement (10) einen viereckigen Rahmen (11) aus metallischem Material aufweist, von dessen äußeren Spitzen sich vier, für die Aufstellung auf den Platten des Plattenbandförderers bestimmte Auflagefortsätze (12) erstrecken und nahe an dessen inneren Spitzen vier ausgesparte Bereiche (13) angelegt sind, die für die Aufnahme und Stützung der Kanten oder Ecken des Substrats (2) einer Schaltungsanordnung (1) bestimmt sind.

2. Halteelement (10) gemäß Anspruch 1,
**dadurch gekennzeichnet,**
daß die inneren Spitzen des Rahmens (11) abgerundet sind.

3. Halteelement (10) gemäß Anspruch 1 oder 2,
**dadurch** **gekennzeichnet**
daß die ausgesparten Bereiche (13) in Draufsicht halbmondförmig ausgebildet sind.

4. Halteelement (10) gemäß irgendeinem der vorhergehenden Ansprüche,
**dadurch gekennzeichnet,**
daß die Auflagefortsätze (12) im wesentlichen eine quadratische Form haben.

5. Halteelement (10) gemäß irgendeinem der vorhergehenden Ansprüche,
**dadurch** **gekennzeichnet,**
daß es aus Aluminium besteht.

## Revendications

1. Elément support (10) portant des circuits hybrides (1) munis d'un substrat en céramique (2) de forme quadrangulaire dans un four à refusion équipé d'un transporteur à lattes, caractérisé en ce qu'il comprend un cadre quadrangulaire (11) en un matériau métallique, à partir des angles extérieurs desquels s'étendent quatre appendices porteurs (12) destinés à être arrangés sur les lattes du transporteur et près des angles intérieurs desquels sont prédisposées quatre zones évidées (13) destinées à recevoir et à supporter les rebords ou les coins du substrat (2) d'un circuit (1).

2. Elément support (10) selon la revendication 1, caractérisé en ce que les angles intérieurs dudit cadre (11) sont arrondis.

3. Elément support (10) selon la revendication 1 ou 2, caractérisé en ce que lesdites zones évidées (13) sont en forme de croissant quand on les voit dans un plan.

4. Elément support (10) selon l'une quelconque des revendications précédentes, caractérisé en ce que lesdits appendices (12) sont sensiblement de forme carrée.

5. Elément support (10) selon l'une quelconque des revendications précédentes, caractérisé en ce qu'il est en aluminium.
